# EUROPEAN PATENT APPLICATION

(11) **EP 1 608 029 A2**
(43) Date of publication of application: **21.12.2005**
(21) Application number: 05012527.7
(22) Date of filing: 10.06.2005
(51) Int. Cl.: H01L 33/00

(54) **Light-emitting device, electronic apparatus, projection-type display device, line head, and image forming device**

(30) Priority: 14.06.2004 JP 2004175469; 15.04.2005 JP 2005117861
(71) Applicant: SEIKO EPSON CORPORATION, Tokyo 160-0811 (JP)
(72) Inventor: Yokoyama, Osamu, Suwa-shi, Nagano-ken 392-8502 (JP); Nojima, Shigeo, Suwa-shi, Nagano-ken 392-8502 (JP)
(74) Representative: HOFFMANN EITLE

(57) **Abstract**

A light-emitting device includes electroluminescent elements, each electroluminescent element having an anode layer; a cathode layer; a plurality of light-emitting layers that are laminated between the anode layer and the cathode layer; transmissive intermediate electrode layers, each being formed between the plurality of light-emitting layers, and a partially reflecting layer. In the light-emitting device, one electrode layer of the anode layer and the cathode layer has transmittance to exit light, and the partially reflecting layer is disposed at the side of that one electrode layer remote from the light-emitting layers, and forms an optical resonator together with the other electrode layer.

## Description

### BACKGROUND OF THE INVENTION

### 1. Technical Field

The present invention relates to a light-emitting device having electroluminescent elements, to an electronic apparatus having the light-emitting device, to a projection-type display device using the light-emitting device as a light source, to a line head using the light-emitting device as a light source, and to an image forming device having the line head.

### 2. Related Art

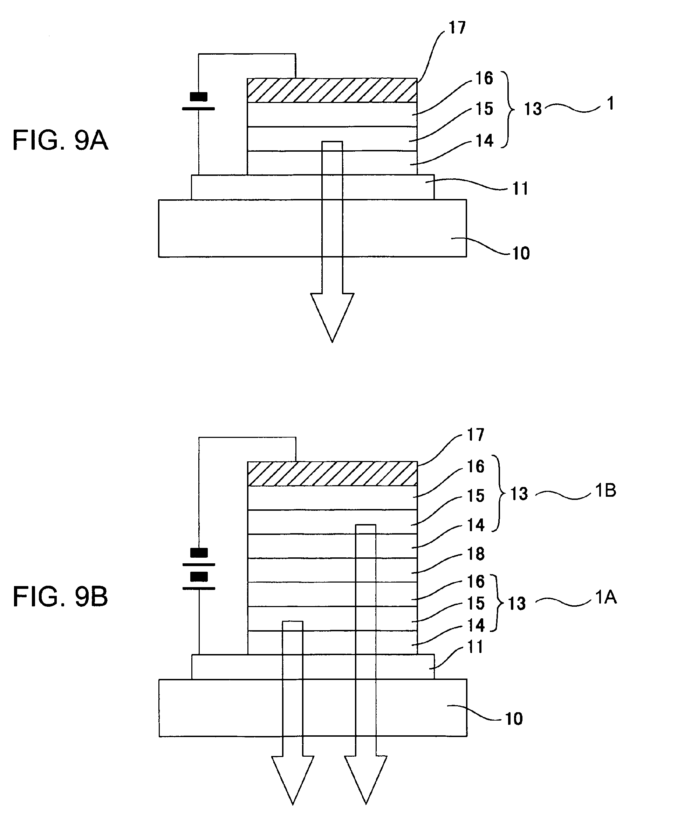

Light-emitting devices having organic electroluminescent (EL) elements as exemplary EL elements have received attention as various flat displays or flat light sources. The organic EL elements typically have an anode layer 11 formed of a transparent conductive material (e.g. Indium Tin Oxide (ITO)), an emitting functional layer 13 composed of a plurality of organic layers (a hole injecting layer 14, a light-emitting layer 15, and an electron injecting layer 16), and a cathode layer 17 formed of Mg, Ag, Ca, AL or the like, which are sequentially laminated in this order on a transmissive substrate 10 as shown in Fig. 9A, and holes injected into the light-emitting layer 15 from the anode side and electrons injected into the light-emitting layer 15 from the cathode side are recombined in the light-emitting layer 15 to emit light. The light exited from the light-emitting layer 15 is externally exited through the anode layer 11 and the substrate 10. In addition, since the cathode layer 17 is composed of a reflective metal electrode, light propagating from the light-emitting layer 15 to the cathode layer 17 is reflected by the cathode layer 17, and then delivered toward the anode layer 11, thereby being externally exited through the anode layer 11 and the substrate 10.

In such an organic EL element 1, since a current injected into the light-emitting layer 15 is converted to light and then exited, it is required to increase a driving current when a conversion efficiency from current to light is low or when a high luminance needs to be obtained. However, in order to increase the driving current, high increase in temperature occurs due to joule heat generated by a resistant component such as wiring lines or within the organic EL element 1, thereby decreasing the lifetime.

Accordingly, a structure has been proposed in which a multi-layered light-emitting functional layer 13 composed of a hole injecting layer 14, a light-emitting layer 15, and an electron injecting layer 16 is formed between the anode layer 11 and the cathode layer 17, while a transmissive intermediate electrode layer 18 is laminated between the respective light-emitting functional layers 13, thereby arranging the organic EL elements 1A and 1B in a multi-stage manner as shown in Fig. 9B (For example, see Japanese Unexamined Patent Application Publication No. 2003-272860).

In addition, in a light-emitting device using an organic EL element, for the purpose of making a peak to be a monochromatic light in a spectrum of exited light or for the purpose of enhancing the directivity of the exited light, one electrode is composed of a totally reflecting portion at one side between the anode layer and the cathode layer film while the other electrode is composed of a transmissive film at the other side, and a multi-layered mirror is laminated on an opposite side to the light-emitting layer of the other electrode to form an optical resonator together with the one electrode, thereby allowing light having a specific wavelength to be intensified and exited (for example, see Japanese Unexamined Patent Application Publication No. 9-180883).

Accordingly, in the light-emitting device in which the organic EL elements 1A and 1B are arranged in a multi-stage manner, an optical resonator may be configured, which allows light having a specific wavelength to be intensified and to be exited at a divergence angle being suppressed. However, when the optical resonator is added to each of the organic EL elements 1A and 1B, it is required to arrange a multi-layered mirror between the organic EL element 1A and the organic EL element 1B. Accordingly, light propagating from the organic EL element 1B to the substrate 10 is reflected by the multi-layered mirror formed between the organic EL element 1A and the organic EL element 1B, thereby decreasing the light exiting efficiency. In addition, when the multi-layered mirror is arranged between the organic EL element 1A and the organic EL element 1B, it becomes impossible to have an electrical conduction in series between the organic EL elements 1A and 1B by the anode layer 11 and the cathode layer 17. Accordingly, it is required to add an electrode layer between the organic EL element 1A and the organic EL element 1B, and this additional electrode layer causes problems in the fabricating process of the organic EL element in which it becomes non-preferably complicated.

### SUMMARY

An advantage of the invention is that it provides a light-emitting device capable of enhancing monochromaticity and directivity of the exited light and capable of enhancing a luminance without increasing a driving current, an electronic apparatus having the light-emitting device, a projection-type display device using the light-emitting device as a light source, a line head using the light-emitting device as a light source, and an image forming device having the line head.

The invention provides a light-emitting device including electroluminescent elements, each electroluminescent element having an anode layer; a cathode layer; a plurality of light-emitting layers that are laminated between the anode layer and the cathode layer; transmissive intermediate electrode layers, each being formed between the plurality of light-emitting layers, and a partially reflecting layer. In the light-emitting device, one electrode layer of the anode layer and the cathode layer has light transmittance to exit light, and the partially reflecting layer is disposed at the side of that one electrode layer remote from the light-emitting layers, and forms an optical resonator together with the other electrode layer.

In the invention, the light-emitting device is configured in a multi-layered manner such that a plurality of light-emitting layers is laminated between the anode layer and the cathode layer with the intermediate electrode layer being interposed therebetween. Accordingly, a luminance can be enhanced without increasing the driving current. In addition, since it is not necessary to increase the driving current, increase in temperature due to the joule heat can be suppressed to be low, thereby capable of enhancing the reliability. Furthermore, in the invention, a partially reflecting layer is formed on an opposite side to the light-emitting layers of one electrode layer with light transmittance of the anode layer and the cathode layer, so as to form an optical resonator for the multi-layered EL elements together with the other electrode layer. Accordingly, unlike a case of forming an optical resonator at each of the multi-layered EL elements, it is not necessary to form the partially reflecting layer between the multi-layered EL elements. Therefore, the light-exiting efficiency becomes high, and an increase in the number of manufacturing processes can be minimized.

In the invention, in any cases of making light emit from any one of the anode layer and the cathode layer, the optical resonator can be configured. For example, when the anode layer, the light-emitting layer, and the cathode layer are formed on a surface of the substrate having transmittance in this order, a structure can be employed that the anode layer has transmittance as the one electrode layer, the cathode layer has total reflectivity as the other electrode layer, and the partially reflecting layer is formed between the substrate and the anode layer.

In the invention, two of the light-emitting layers are preferably formed between the anode layer and the cathode layer. When the number of stages of the light-emitting layers increases, an optical path within the optical resonator becomes too long, causing a resonating mode of high order to occur, therefore, the number of stages of the light-emitting layer is preferably two.

In the invention, the electroluminescent element is an organic electroluminescent element in which the light-emitting layers are formed of organic materials.

In the invention, it is preferable to make light having a light-emitting spectrum with a single peak be exited from the one electrode layer. In addition, a full width at half maximum of the light-emitting spectrum is preferably 30 nm or less. By means of such a structure, the light-emitting device to which the present invention is applied can be used as a color light source.

In the invention, a transmittance of the intermediate electrode layer is preferably 80% or more. By means of such a structure, an energy loss of light at the intermediate electrode layer can be minimized, thereby enhancing the light exiting efficiency.

In the invention, a reflectance of the partially reflecting layer is preferably 50% or more. By means of such a structure, an effect of the optical resonator is high.

The light-emitting device to which the invention is applied can be used as a display unit or a light source in various electronic apparatuses. For example, the light-emitting device to which the present invention is applied can be used as a light source of a projection-type display device, and such a projection-type display device has an optical modulating device modulating color light components exited from the light-emitting device and a projection optical system projecting light exited from the optical modulating device.

The light-emitting device to which the invention is applied can be used as a light source of a line head used in an image forming device. In this case, a plurality of electroluminescent elements is arranged in the light-emitting device. In addition, in the image forming device having the line head associated with the invention has a plurality of imaging lens for imaging light exited from the plurality of electroluminescent elements. In the invention, since the electroluminescent element has a multi-layered structure, the luminance can be enhanced without increasing the driving current. In addition, since it is not necessary to increase the driving current, increase in temperature due to the joule heat can be suppressed to be low, thereby capable of increasing the lifetime of the line head. Accordingly, an exchange frequency of the line head can decrease in the image forming device. Furthermore, according to the electroluminescent element to which the invention is applied, a diameter of a spot focused on the image formation surface of a photosensitive drum or the like can be made to be small, thereby capable of printing images with a high resolution by means of the image forming device using the line head.

### BRIEF DESCRIPTION OF THE DRAWINGS

The invention will be described with reference to the accompanying drawings, wherein like numbers reference like elements, and wherein:
Fig. 1 is a cross-sectional view schematically illustrating a structure of a light-emitting device associated with a first embodiment of the present invention;
Fig. 2 is a cross-sectional view schematically illustrating a structure of a light-emitting device associated with a second embodiment of the invention;
Fig. 3 is an explanatory view illustrating an example in which a light-emitting device to which the invention is applied is mounted in a projection-type display device (e.g. electronic apparatus);
Fig. 4 is an explanatory view illustrating an example in which a light-emitting device to which the invention is applied is mounted in a projection-type display device (e.g. electronic apparatus) using a reflective-type optical modulation device;
Fig. 5 is a block diagram illustrating an active matrix type display device (e.g. electronic apparatus) using a light-emitting device to which the invention is applied;
Fig. 6 is a side cross-sectional view of a line head module using an image forming device (e.g. electronic apparatus) to which the invention is applied;
Fig. 7 is an explanatory view illustrating a positional relationship among a line head module, a lens array, and a photosensitive drum in the image forming device to which the invention is applied;
Fig. 8 is a plan view illustrating a line head for an image forming device to which the invention is applied; and
Figs. 9A and 9B are cross-sectional views schematically illustrating a structure of a light-emitting device in accordance with the related art.

### DESCRIPTION OF THE EMBODIMENTS

Embodiments of the present invention will be described with reference to drawings. In the respective drawings for reference, magnification or scale is differently applied for each layer or each member for easy recognition.

### First embodiment

### Overall Structure

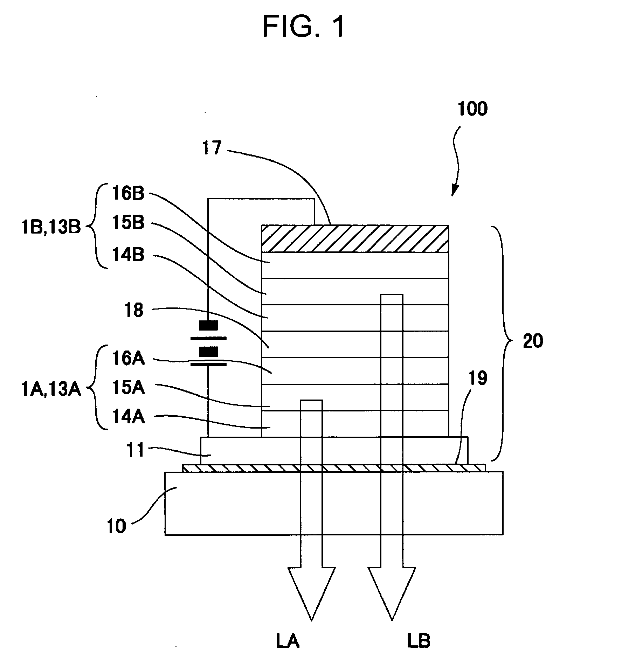

Fig. 1 is a cross-sectional view schematically illustrating a structure of a light-emitting device according to a first embodiment of the present invention.

Referring to Fig. 1, the light-emitting device 100 of the present embodiment is an organic EL light-emitting device having an organic EL element as an electroluminescent element. In the light-emitting device 100 of the present embodiment, on a substrate 10, light-emitting functional layers 13A and 13B having light-emitting layers 15A and 15B are laminated in two stages between an anode layer 11 and a cathode layer 17, and an intermediate electrode layer 18 having light transmittance is formed between the light-emitting functional layers. Each of the two light-emitting functional layers 13A and 13B is configured such that hole injecting layers 14A and 14B, the light-emitting layers 15A and 15B, and electron injecting layers 16A and 16B are laminated in this order.

The intermediate electrode layer 18 is formed of a conductive film such as ITO having transmittance, and its transmittance is 80% or more. In the embodiment, the intermediate electrode layer 18 acts as a cathode layer together with the electron injecting layer 16A with respect to the lower light-emitting functional layer 13A while acting as an anode layer with respect to the upper light-emitting functional layer 13B. This is why the two organic EL elements 1A and 1B are laminated in two-stages on the substrate 10 having transmittance in the light-emitting device 100 of the embodiment.

The light-emitting device 100 of the embodiment corresponds to a bottom-emission-type light-emitting device, which emits light from the substrate 10. Accordingly, a transmissive substrate formed of glass or the like is used as the substrate 10. In addition, a transmissive conductive layer formed of ITO or the like is used as the anode layer 11. The cathode layer 17 is formed of a thick reflective metal layer formed of Al, Mg, and so forth. Accordingly, in the organic EL element 1A, light generated in the light-emitting layer 15A exits from the substrate 10 as indicated by an arrow LA. In addition, the light propagating from the light-emitting layer 15A to the cathode layer 17 is totally reflected by the cathode layer 17 and then exits from the substrate 10. Similarly, in the organic EL element 1B, light generated in the light-emitting layer 15B exits from the substrate 10 as indicated by an arrow LB. In addition, the light propagating from the light-emitting layer 15B to the cathode layer 17 is totally reflected by the cathode layer 17 and then exits from the substrate 10.

In this case, the wavelength (colors) of the light generated in the light-emitting layers 15A and 15B is defined by the materials constituting the light-emitting layers 15A and 15B, respectively.

In the embodiment, polymer materials such as polythiophene, polystyrene sulfonic acid,polyphenilene vinylene, polypyrrole, polyaniline, and derivatives thereof may be used as the hole injecting layers 14A and 14B. The derivatives may include, for example, 3, 4-polyethylenedioxythiophene, or the like.

In addition, low molecular materials used for the hole injecting layers 14A and 14B include copperphthalocyanine, 1-1-bis-[(4-[N,N-(ditolyl)amino]phenyl)cyclohexane, tris(8-hydroxyquinolinol)aluminum, and so forth. Furthermore, when the low molecular materials are used for the hole injecting layers 14A and 14B, it is preferable to form a hole transporting layer between the light-emitting layers 15A and 15B and the hole injecting layers 14A and 14B shown in Fig. 1.

Polymer light-emitting materials or organic EL dyes of a low molecular system such as various fluorescent materials and phosphoric materials may be used for forming the light-emitting layers 15A and 15B. Representative materials of a conjugated polymey system used for the light-emitting layers 15A and 15B may include an allylenevinylene or polyfluorene structure. A low molecular material used for forming the light-emitting layers 15A and 15B may include, naphthalene derivatives, anthracene derivatives, dyes such as perylene derivatives, polymethine, xanthene, coumarin and cyanine, 8-hydroquinoline and metal complexes of its derivative, aromatic amine, and tetraphenylcyclopentadiene derivatives.

The electron injecting layers 16A and 16B may be formed of oxides or fluorides of alkaline metals or alkaline earth metals, and in particular, it is preferably formed of the fluorides of the alkaline earth metals. In addition, the electron injecting layer 16A may be formed of an organic compound.

Furthermore, each of the electron injecting layer 16B and the hole injecting layer 14A may be omitted in response to the work function of each of the cathode layer 17 and the anode layer 11. For example, when the cathode layer 17 is formed of Mg, Ag, Ca, or the like, to the electron injecting layer 16B can be omitted. In addition, the hole injecting layer 14B may be omitted in response to a work function of the intermediate electrode layer 18.

In addition, in the light-emitting device 100 of the embodiment, a partially reflecting layer 19 constituting the optical resonator 20 is laminated on an opposite side to the light-emitting layers 15A and 15B of the anode layer 11, so as to construct an optical resonator 20 together with the cathode layer 17 between the substrate 10 and the anode layer 11, and the reflectance of the partially reflecting layer 19 is 50% or more, for example, 50% to 70%. Accordingly, in the organic EL elements 1A and 1B, as indicated by the arrows LA and LB, when light generated from the light-emitting layers 15A and 15B exits from the substrate 10 or when the light propagates toward the cathode layer 17 from the light-emitting layers 15A and 15B and is reflected by the cathode layer 17 and exits from the substrate 10, a portion thereof is reflected by the partially reflecting layer 19 to propagate toward the cathode layer 17, and is reflected by the cathode layer 17 again to propagate toward the partially reflecting layer 19. Accordingly, when the wavelength of the light exiting is λ and an optical length of an optical path formed by the anode layer 11, the hole injecting layer 14A, the light-emitting layer 15A, the electron injecting layer 16A, the intermediate electrode layer 18, the hole injecting layer 14B, the light-emitting layer 15B, and the electron injecting layer 16B (the total sum of the products of the thickness and the refraction factor of the respective layers) is set to an integral multiple of λ/4, a standing wave having a predetermined wavelength becomes present between the cathode layer 17 and the partially reflecting layer 19, thereby capable of sharpening the light-emitting spectrum of the light to be exited and enhancing the directivity in an optical radiation distribution.

In this case, metal layers such as a thin aluminum layer can be used as the partially reflecting layer 19, and with this partially reflecting layer 19, the number of manufacturing processes advantageously decreases. In addition, a multi-layer mirror composed of a multi-layer of TiO₂ and SiO₂, a multi-layer of SiN_{X} and SiO₂, and a multi-layer of Ta₂O₅ and SiO₂ can be used as the partially reflecting layer 19.

### Main effect of the first embodiment

In the light-emitting device 100 constructed in this way, two light-emitting layers 15A and 15B are laminated between the anode layer 11 and the cathode layer 17 with the intermediate electrode layer 18 being interposed between the light-emitting layers, and the organic EL elements 1A and 1B are formed in a two-stage manner. Accordingly, a luminance can be enhanced without increasing the driving current.

That is, when the number of stages of the organic EL element is n and the driving current and the luminance are I₀ and L₀ when the number of stages is one, the driving voltage becomes n times, while the luminance can increase to n·L₀ while the driving current is kept at I₀. On the contrary, when the luminance L₀ of the one-stage structure is required, the driving current can decrease to I₀/n while the driving voltage stays the same. In addition, since it is not necessary to increase the driving current, the increase in temperature due to the joule heat can be suppressed to be low, thereby capable of enhancing the reliability of the light-emitting device 100.

In this case, the number of stages of the organic EL elements may be three or more. However, in the embodiment, since the number of stages of the organic EL elements is two, an interval between the partially reflecting layer 19 and the cathode layer 17 is narrow. Accordingly, light having unnecessary wavelengths generated by a resonating mode of high order can be prevented from exiting .

Furthermore, the partially reflecting layer 19 is formed on an opposite side to the light-emitting layers 15A and 15B of the anode layer 11, and this partially reflecting layer 19 constitutes the optical resonator 20 with respect to all of the two-staged organic EL elements 1A and 1B between the cathode layer 17 and the partially reflecting layer 19. In addition, in the embodiment, the effective reflection coefficient of the cathode layer 17 is set high, and the transmittance of the intermediate electrode layer 18 is set to 80% or more by adjusting its thickness so that the optical energy loss decreases, and in order to enhance the resonance effect, the effective reflection coefficient of the partially reflecting layer 19 is set to 50% or more so as to correspond to the effective reflection coefficient of the cathode layer 17. Furthermore, the thickness of each layer is set so as to make stronger an interference effect between the light exited from the organic EL element 1A and the light exited from the organic EL element 1B. Accordingly, only light having a specific wavelength can be intensified, so that light having a light-emitting spectrum with a single peak can be exited, and a full width at half maximum of the light-emitting spectrum can be narrowed to 30 nm or less.

In addition, in the embodiment, the optical resonator 20 is formed, so that the directivity of the exited light can be enhanced. Accordingly, in case of using the optical resonator as a light source of a projection-type display device to be described later, light can be exited within an angle range determined by a numerical aperture of its projection lens. Accordingly, there is less loss of light as compared to a light source isotropically emitting light, thereby capable of displaying a bright image.

For example, when a reflectance at an interface between the anode layer 11 and the hole injecting layer 12 is about 50%, its transmittance is about 25%, a transmittance of the intermediate electrode layer 18 is about 90%, and a reflectance at an interface between the cathode layer 17 and the electron injecting layer 16B is 85%, a full width at half maximum of the light-emitting spectrum can be narrowed up to 20 nm, and the bandwidth of the light-emitting spectrum can be narrowed as compared to a case of the absence of the optical resonator 20. In addition, when the normal direction of the substrate 10 is front and an intensity of the light at the front is one, the angle from the normal line having the intensity of 1/2 was about 60° when the optical resonator 20 was not present, however, is about 45° in accordance with the embodiment, thereby capable of enhancing the directivity.

Furthermore, in the embodiment, the partially reflecting layer 19 constitutes the optical resonator 20 with respect to all of the two-staged organic EL elements 1A and 1B between the cathode layer 17 and the partially reflecting layer, so that it is not necessary to form the partially reflecting layer between the two organic EL elements 1A and 1B unlike the case of forming the optical resonator at each of the two-staged organic EL elements 1A and 1B. Accordingly, the light exiting efficiency can be enhanced, and the number of manufacturing processes can be minimized.

### Second embodiment

In the first embodiment, the invention has been applied to the bottom-emission-type light-emitting device 100. However, the invention may be applied to a top-emission-type light-emitting device 100 as will be hereinafter described. Furthermore, since the light-emitting device of the second embodiment has a basic structure same as that of the first embodiment, parts having common functions are given with the same references and description thereof will be skipped.

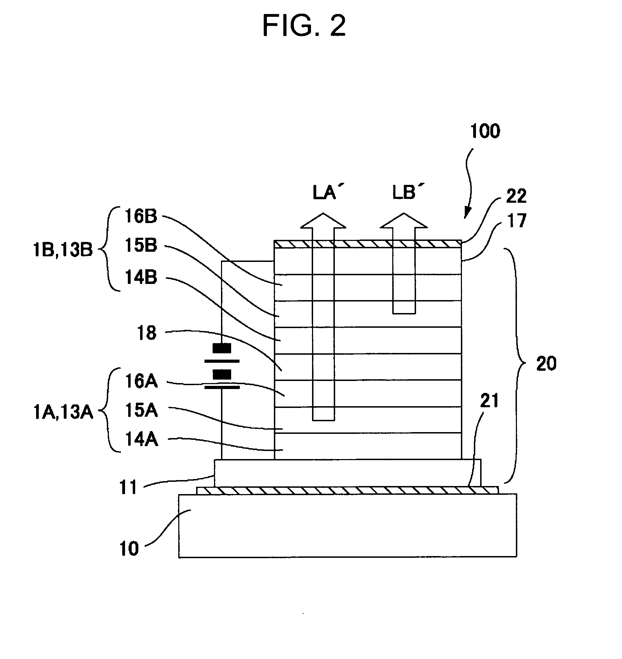

Fig. 2 is a cross-sectional view schematically illustrating a structure of the light-emitting device associated with the second embodiment of the invention.

Referring to Fig. 2, the light-emitting device 100 of the present embodiment is an organic EL light-emitting device having an organic EL element as an EL element, and light-emitting functional layers 13A and 13B having light-emitting layers 15A and 15B are laminated in two-stage manner between an anode layer 11 and a cathode layer 17, and an intermediate electrode layer 18 having transmittance is formed between the light-emitting functional layers. The two light-emitting functional layers 13A and 13B have hole injecting layers 14A and 14B, the light-emitting layers 15A and 15B, and electron injecting layers 16A and 16B laminated in this order, respectively.

The intermediate electrode layer 18 is formed of a conductive layer having transmittance such as ITO, and acts as a cathode layer together with the electron injecting layer 16A with respect to the lower light-emitting functional layer 13A while acting as an anode layer with respect to the upper light-emitting functional layer 13B. This is why the two organic EL elements 1A and 1B are laminated in two stages on the substrate 10 having transmittance in the light-emitting device 100 of the embodiment.

The light-emitting device 100 of the embodiment corresponds to the top-emission-type light-emitting device, which emits light from the cathode layer 17. Accordingly, various substrates as well as a transmissive substrate formed of glass or the like can be used as the substrate 10. In addition, the anode layer 11 is formed of a transmissive conductive layer such as ITO, however, a totally reflecting layer 21 formed of a metal layer such as Al, Mg, Au, and Ag is formed below the anode layer. In the meantime, the cathode layer 17 is formed of a transmissive conductive layer made of ITO or the like. Accordingly, in the organic EL element 1A, light generated by the light-emitting layer 15A exits from an opposite to the substrate 10 of the light-emitting layer as indicated by an arrow LA'. In addition, light propagating toward the substrate 10 from the light-emitting layer 15A is totally reflected by the totally reflecting layer 21 and then exited from the side opposite to the substrate 10. Similarly, in the organic EL element 1B, light generated in the light-emitting layer 15B exits from the opposite side to the substrate 10 of the light-emitting layer as indicated by the arrow LB'. In addition, light propagating from the light-emitting layer 15B to the anode layer 11 is totally reflected by the totally reflecting layer 21 and then exited from the side opposite to the substrate 10.

In addition, in the light-emitting device 100 of the embodiment, on an opposite to the light-emitting layers 15A and 15B of the cathode layer 17, that is, on the upper side of the cathode layer 17, a partially reflecting layer 22 constituting the optical resonator 20 is formed between the totally reflecting layer 21 (the side of the anode layer 11) and the partially reflecting layer. Accordingly, in the organic EL elements 1A and 1B, as indicated by the arrows LA' and LB', when the light generated in the light-emitting layers 15A and 15B exits from the side opposite to the substrate 10 or when the light propagates toward the anode layer 11 from the light-emitting layers 15A and 15B and is reflected by the totally reflecting layer 21 and exited from the side opposite to the substrate 10, a portion thereof is reflected by the partially reflecting layer 22 to propagate toward the anode layer 11, and is reflected by the totally reflecting layer 21 again to propagate toward the partially reflecting layer 22. Accordingly, when the wavelength of the light to be exited is λ and an optical length of an optical path formed by the anode layer 11, the hole injecting layer 14A, the light-emitting layer 15A, the electron injecting layer 16A, the intermediate electrode layer 18, the hole injecting layer 14B, the light-emitting layer 15B, and the electron injecting layer 16B (the total sum of the products of the thickness and the refraction factor of the respective layers) is set to an integral multiple of λ/4, a standing wave of light having a predetermined wavelength becomes present between the totally reflecting layer 21 (the side of the anode layer 11) and the partially reflecting layer 22, thereby capable of sharpening the light-emitting spectrum of light exiting and enhancing the directivity in the optical radiation distribution.

In this case, metal layers such as a thin aluminum layer is used as the partially reflecting layer 22. And a multi-layer mirror composed of a multi-layer of TiO₂ and SiO₂, a multi-layer of SiNₓ and SiO₂, and a multi-layer of Ta₂O₅ and SiO₂ can be used as the partially reflecting layer 22.

Also in the light-emitting device 100 constructed in this way, two light-emitting layers 15A and 15B are laminated in two stages, so that a luminance can be enhanced without increasing the driving current. In addition, since it is not necessary to increase the driving current, increase in temperature due to the joule heat can be suppressed to be low, thereby capable of enhancing the reliability of the light-emitting device 100.

Furthermore, the partially reflecting layer 22 constituting the optical resonator 20 with respect to all of the organic EL elements 1A and 1B formed in two stages is formed on the cathode layer 17 between the anode layer 11 and the cathode layer 17. Accordingly, unlike a case of forming an optical resonator at each of the organic EL elements 1A and 1B formed in two stages, it is not necessary to form the partially reflecting layer between the two organic EL elements 1A and 1B. Therefore, the light-emitting device 100 represents the same effect as that of the first embodiment. In other words, the light exiting efficiency becomes high, and increase in the number of manufacturing processes can be minimized.

### Third embodiment

In the above-described first and second embodiments, light exits only from the side of the substrate 10 or an opposite side to the side of the substrate 10. However, a light-emitting device allowing light to exit from both sides can be implemented by means of a combination of the first and second embodiments.

### First example of mounting light-emitting device into electronic apparatus

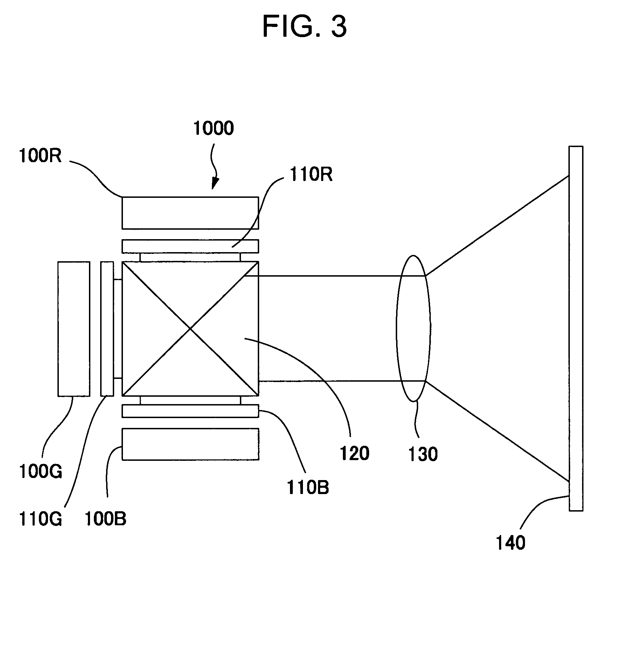

Fig. 3 is an explanatory view illustrating an example in which a light-emitting device to which the invention is applied is mounted in a projection-type display device (e.g. electronic apparatus) using a liquid crystal device.

The light-emitting device 100 to which the invention is applied allows predetermined color light components exiting by selecting material qualities of the light-emitting layers 15A and 15B. Accordingly, as shown in Fig. 3, light-emitting devices 100R, 100B, and 100G for each color of Red (R), green (G), and blue (B), and transmission-type liquid crystal devices 110R, 110B, and 110G (optical modulation devices) for R, G, and B are prepared, which are disposed with regard to three sides of the optical path synthesizing prism 120 while a projection optical system 130 is disposed with regard to the other side of the optical path synthesizing prism 120, thereby making the projection-type display device 1000.

In the projection-type display device 1000 having the above-described structure, color light components exiting from the light-emitting devices 100R, 100B, and 100G are optically modulated by the transmission-type liquid crystal devices 110R, 110B, and 110G, are synthesized by the optical path synthesizing prism 120, and are enlarged and projected onto the screen 140 by the projection optical system 130. In this case, since each color light component is light exiting from each of the light-emitting devices 100R, 100B, and 100G, the number of optical components may be less as compared to the conventional projection-type display device which divides white light component into color light components and then makes them introduced into the liquid crystal devices 110R, 110B, and 110G for respective colors. Therefore, a small-size, light-weight, and a low cost can be implemented for the projection-type display device 1000.

In addition, since the optical resonator 20 described with reference to Figs. 1 and 2 is disposed at each of the light-emitting devices 100R, 100B, and 100G, the directivity of exiting light is high. Accordingly, when the light-emitting devices 100R, 100B, and 100G to which the invention is applied are used as light sources, light can exit within an angle range determined by a numerical aperture of the projection lens used in the projection optical system 130. Accordingly, there is less loss of light as compared to the light source isotropically emitting light, thereby capable of displaying a bright image.

Furthermore, the projection-type liquid crystal devices 110R, 110B, and 110G are used as the optical modulation devices in the projection-type display device 1000 shown in Fig. 3, and a reflective-type liquid crystal display device may be used as the optical modulation device.

### Second example of mounting light-emitting device into electronic apparatus

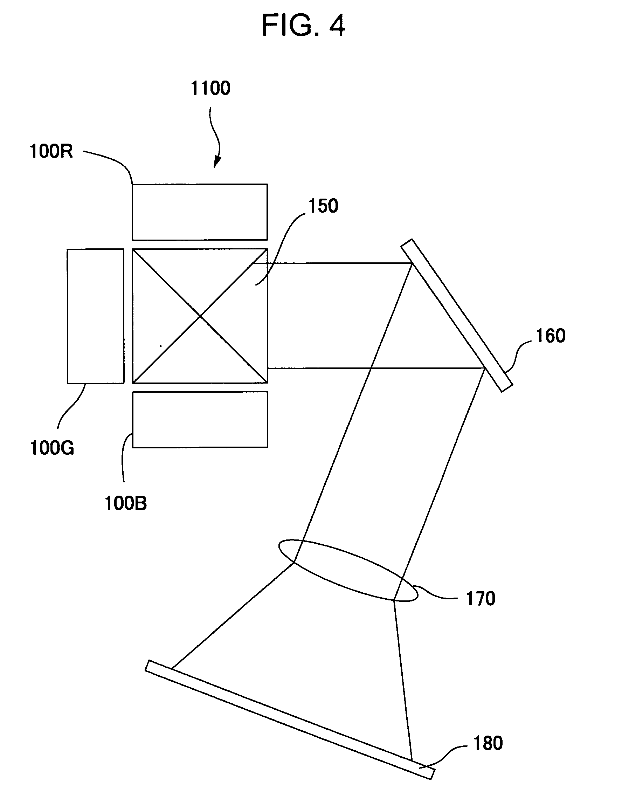

Fig. 4 is an explanatory view illustrating an example in which a light-emitting device to which the invention is applied is mounted in a projection-type display device (e.g. electronic apparatus) using a reflective-type optical modulation device in which a micro mirror is formed per pixel.

The light-emitting device 100 to which the invention is applied allows a predetermined color light component to exit by selecting material qualities of the light-emitting layers 15A and 15B. Accordingly, color light components exiting from the light-emitting devices 100R, 100B, and 100G for respective colors of R, G, and B may be made exit from an optical path synthesizing prism 150 toward a substrate 160 in which a plurality of micro reflective mirrors is formed in a matrix, as in the case of the projection-type display device 1100 shown in Fig. 4.

In the projection-type display device 1100 having the above-described structure, the color light components exiting from the optical path synthesizing prism 150 are optically modulated by the reflective-type optical modulation device per color and then enlarged and projected onto a screen 180 from a projection optical system 170.

In addition, a plurality of organic EL elements each emitting a predetermined color light component may be disposed on the same substrate in a matrix and may be driven per color in a time-division manner, so that the predetermined color light component may exit toward the optical modulation device of the reflective-type optical modulation device shown in Fig. 4. By means of this structure, only one light-emitting device can constitute the light source, and the optical path synthesizing prism is not necessary.

### Third example of mounting light-emitting device into electronic apparatus

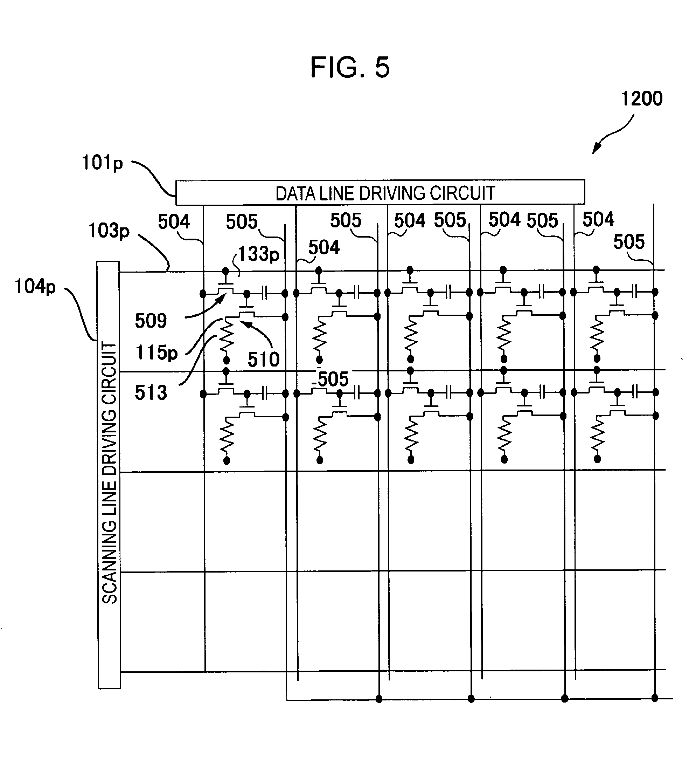

Fig. 5 is a block diagram illustrating a direct-view-type active matrix display device (e.g. electronic apparatus) using a light-emitting device to which the invention is applied.

In the organic EL display device 1200 (light-emitting device) shown in Fig. 5, the organic EL elements shown in Fig. 1 or Fig. 2 are arranged in predetermined patterns of respective colors in each of pixels, thereby displaying a color image. In the organic EL display device 1200 shown herein, a plurality of scanning lines 103p, a plurality of data lines 504 extending in a direction crossing the direction in which the scanning lines 103p extend, a plurality of common feed lines parallel with the data lines 504, and a plurality of pixels 115p each corresponding to an intersection between the data line 504 and the scanning line 103p are formed, and the pixels 115p are disposed in a matrix in an image display region. A data line driving circuit 101p having a shift register, a level shifter, a video line, and an analog switch is disposed with regard to the data lines 504. A scanning line driving circuit 104p having a shift register and a level shifter is disposed for the scanning line 103p. In addition, each of the pixels 115p has a switching thin film transistor 509 in which a scan signal is supplied to the gate electrode through the scanning line 103p, a storage capacitor 133p storing an image signal supplied from the data line 504 through the switching thin film transistor 509, a current thin film transistor 510 in which the image signal stored in the storage capacitor 133p is supplied to its gate electrode, and an organic EL element 513 into which a driving current flows from the common feed line 505 when electrically connected to the common feed line 505 by the current thin film transistor 510. The organic EL element 513 has the structure described with reference to Fig. 1 or Fig. 2, and the cathode layer 17 described with reference to Figs. 1 and 2 is formed as a counter electrode across the plurality of pixels 115p over the data lines 504. In addition, a pixel electrode is formed by the anode layer 11 described with reference to Figs. 1 and 2.

In the organic EL display device 1200 having the above-described structure, when the switching thin film transistor 509 is driven by the scanning line 103p, a current corresponding to the data line 504 flows in the organic EL element 513. Accordingly, a predetermined color light component exits from the organic EL element 513, thereby displaying a color image.

### Fourth example of mounting light-emitting device into electronic apparatus

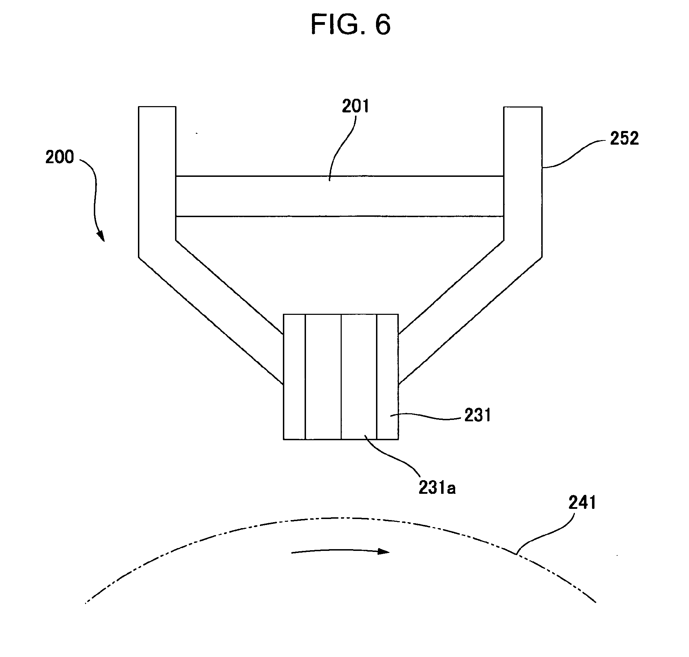

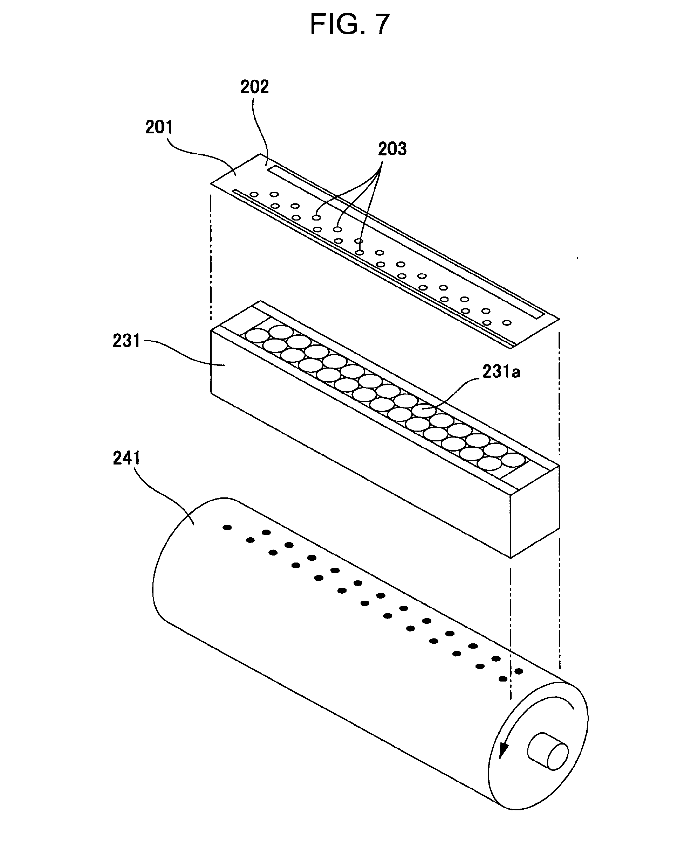

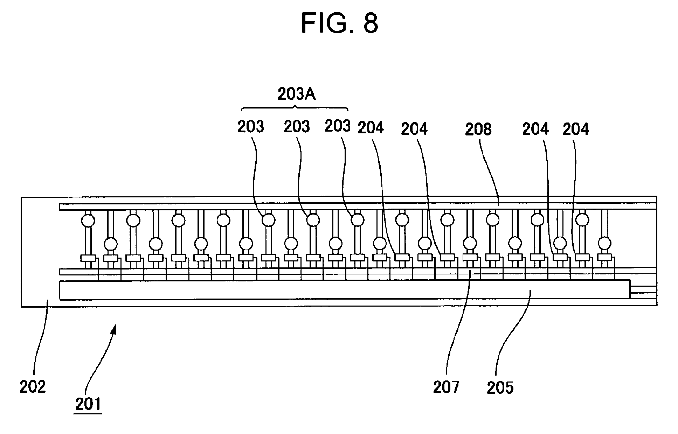

Fig. 6 is a side cross-sectional view of a line head module using an image forming device (e.g. electronic apparatus) to which the invention is applied. Fig. 7 is an explanatory view illustrating a positional relationship among a line head module, a lens array, and a photosensitive drum in the image forming device to which the invention is applied. Fig. 8 is a plan view illustrating a line head for the image forming device to which the invention is applied.

Referring to Figs. 6 and 7, the line head module 200 is a module used as an exposure device in an image forming device to be described below, and has a line head 201 in which a plurality of organic EL elements 203 is arranged, and a lens array 231 (rod lens array) in which rod lenses 231a for forming an erect unmagnified image of light from the line head 201 are arranged, the line head 201 and the lens array 231 being fixed to a light source case 252. In this line head module 200, when light exiting from the organic EL elements 203 arranged in the line head 201 is made to be incident on the rod lenses 231a constituting the lens array 231, an unmagnified image is formed on an outer peripheral surface of a photosensitive drum 241 and then exposed.

Referring to Fig. 8, the line head 201 has light-emitting element rows 203A comprised of a plurality of organic El elements 203 arranged on an elongated rectangular element substrate 202, a driving element group composed of driving elements 204 for driving the organic EL elements 203, and a control circuit group 205 for controlling driving of these driving elements 204, which are assembled as one body. The two light-emitting element rows 203A are formed in the embodiment, and the organic EL elements 203 in the two light-emitting element rows 203A are disposed in a zigzag. By means of such a structure, an apparent pitch is made to be narrow between the organic EL elements 203 in the elongated direction of the line head 201. Furthermore, only one light-emitting layer row 203A may be disposed.

A power line 208 is connected to an electrode at one side of each of the organic EL elements 203 and a power line 207 is connected to an electrode at the other side via the driving element 204. This driving element 204 is composed of a switching element such as a thin film transistor (TFT) or a thin film diode (TFD). When the TFT is employed as the driving element 204, the power line 208 is connected to its source region, and the control circuit group 205 is connected to its gate electrode. Furthermore, operation of the driving element 204 is controlled by the control circuit group 205, and energization to the organic EL element 203 is controlled by the driving element 204.

In this case, the line head 201 is arranged such that its light exiting surface faces the photosensitive drum 241. At this time, a row direction (a direction in which the light-emitting elements are arranged) of the light-emitting element rows 203A are made to be in parallel with a rotational axis of the photosensitive drum 241.

When the light-emitting device to which the present invention is applied is used as the light source in the line head 201 having the above-described structure, since the organic EL elements 203 are formed in a multi-stage manner, the luminance can be enhanced without increasing the driving current. In addition, since the driving current does not need to increase, increase in temperature due to the joule heat can be suppressed to be low, thereby capable of increasing the lifetime of the line head 201. Accordingly, an exchange frequency of the line head 201 can be low in the image forming device. Furthermore, according to the organic EL element 203 to which the present invention is applied, a diameter of a spot focused on the photosensitive drum 241 can be made small, thereby capable of printing images with a high resolution by means of the image forming device using the line head 201.

As the image forming device, there are a tandem-type image forming device in which an exposure device is disposed at each of the plurality of photosensitive drums corresponding to each color, and an image forming device so called a four cycle type. A whole structure of each of these image forming devices is not shown, however, in the tandem-type image forming device, a plurality of photosensitive drums, for example, corresponding to black, cyan, magenta, and yellow is disposed along a moving direction of an intermediate transfer belt. In addition, around each of the photosensitive drums is disposed an electrification device for uniformly electrifying an outer peripheral surface of each photosensitive drum, a line head module sequentially scanning the outer peripheral surface uniformly electrified by the electrification device line-by-line in synchronization with a rotation of the photosensitive drum, and a developing device. The line head module is disposed so as to make the array direction of each line head (a direction in which the organic EL elements are arranged) be in parallel with the rotational axis of the photosensitive drum. In addition, the line head module and the photosensitive drum are configured so as to make a light-emitting energy peak wavelength of the line head module match the sensitivity peak wavelength of the photosensitive drum. The developing device, for example, uses non-magnetic one component toner as a developer, and carries the one component developer to a developing roller by means of a supplying roller while defining, with a blade, a layer thickness of the developer attached on a surface of the developing roller. In addition, the developing roller is contacted with or pressed to the photosensitive drum, and the developer is attached thereto in response to an electrical potential level of the photosensitive drum, thereby being developed as a toner image.

The toner images corresponding to respective colors formed on the photosensitive drum is sequentially primary-transferred onto an intermediate transfer belt by means of a primary transfer bias applied to a primary transfer roller, which then overlap with each other on the intermediate transfer belt in a sequential manner, thereby forming a toner image of full color. The toner image is secondary-transferred onto a recording medium such as a paper by a secondary transfer roller, and then fixed on the recording medium by being passed between a pair of fixing rollers.

Furthermore, in the four cycle type image forming device, a development rotary unit of which the inside is divided into four spaces is used as the developing device, and image formation units corresponding to yellow, cyan, magenta, and black are disposed in the four divided spaces. Such an image forming device has the line head module sequentially carrying out line scanning in synchronization with the rotation of the photosensitive drum, as the tandem-type image forming device.

### Other embodiment

In addition, the technical scope of the invention is not limited to the above-described embodiments, and various changes may be added without departing from the spirit and scope of the invention, and specific materials or structures described in the above-described embodiments are just examples, and may be appropriately changed.

## Claims

1. A light-emitting device comprising:
electroluminescent elements,
wherein each electroluminescent element has:
an anode layer;
a cathode layer;
a plurality of light-emitting layers that are laminated between the anode layer and the cathode layer;
transmissive intermediate electrode layers, each being formed between the plurality of light-emitting layers; and
a partially reflecting layer,
wherein one electrode layer of the anode layer and the cathode layer has transmittance to exit light, and the partially reflecting layer is disposed at the side of that one electrode layer remote from the light-emitting layers, the partially reflecting layer forming an optical resonator together with the other electrode layer.

2. The light-emitting device according to Claim 1,
wherein the anode layer, the plurality of light-emitting layers, and the cathode layer are formed on a surface of a substrate having transmittance in this order,
the anode layer has transmittance as the one electrode layer,
the cathode layer has total reflectivity as the other electrode layer, and
the partially reflecting layer is formed between the substrate and the anode layer.

3. The light-emitting device according to Claim 1,
wherein two of the light-emitting layers are formed between the anode layer and the cathode layer.

4. The light-emitting device according to Claim 1,
wherein the electroluminescent element is an organic electroluminescent element in which the light-emitting layers are formed of organic materials.

5. The light-emitting device according to Claim 1,
wherein light having a light-emitting spectrum with a single peak exits from the one electrode layer.

6. The light-emitting device according to Claim 5,
wherein a full width at half maximum of the light-emitting spectrum is 30 nm or less.

7. The light-emitting device according to Claim 1,
wherein the transmittance of the intermediate electrode layer is 80% or more.

8. The light-emitting device according to Claim 1,
wherein the reflectance of the partially reflecting layer is 50% or more.

9. An electronic apparatus comprising the light-emitting device according to Claim 1.

10. A projection-type display device using the light-emitting device according to Claim 1 as a light source, comprising:
an optical modulating device that modulates color light components exiting from the light-emitting device; and
a projection optical system that projects light exiting from the optical modulating device.

11. A line head using the light-emitting'device according to Claim 1 as a light source,
wherein a plurality of electroluminescent elements is arranged in the light-emitting device.

12. An image forming device having the line head according to Claim 11, comprising:
a plurality of imaging lens that images light exiting from the plurality of electroluminescent elements.
